# EUROPÄISCHE PATENTANMELDUNG

(11) **EP 4 524 670 A1**
(43) Veröffentlichungstag der Anmeldung: **19.03.2025**
(21) Anmeldenummer: 23197416.3
(22) Anmeldetag: 14.09.2023
(51) Int. Cl.: G05B 23/02, G06Q 10/06, G06Q 50/08

(54) **COMPUTERUNTERSTÜTZTES VERFAHREN ZUR BEREITSTELLUNG EINES DIGITALEN MODELLS EINER BAUSTELLENEINRICHTUNG**

(71) Anmelder: PERI SE, 89264 Weißenhorn (DE)
(72) Erfinder: Nowotny, Konstantin, 89264 Weißenhorn (DE)
(74) Vertreter: Müller Schupfner & Partner Patent- und Rechtsanwaltspartnerschaft mbB (Muc)

(57) **Zusammenfassung**

Computerunterstütztes Verfahren zur Bereitstellung eines digitalen Modells einer Baustelleneinrichtung, insbesondere zur real-time Überwachung der Baustelleneinrichtung, wobei die Baustelleneinrichtung durch Einrichtungselemente aufgebaut wird, umfassend: Bereitstellen (10) von Sensordaten, umfassend Informationen, die für eine Verwendung eines jeweiligen Einrichtungselements während des Auf-, Ab- oder Umbaus der Baustelleneinrichtung spezifisch sind; Bereitstellen (20) eines Auswertungsmodells, das eingerichtet ist, um basierend auf den Sensordaten ein digitales Modell der Baustelleneinrichtung bereitzustellen; Bereitstellen (30) eines digitalen Modells der Baustelleneinrichtung durch Anwendung des Auswertungsmodells und der bereitgestellten Sensordaten.

## Beschreibung

### Gebiet der Erfindung

Die vorliegende Erfindung betrifft ein computerunterstütztes Verfahren zur Bereitstellung eines digitalen Modells einer Baustelleneinrichtung, insbesondere zur real-time Überwachung der Baustelleneinrichtung, ein System zur Bereitstellung eines solchen digitalen Modells einer Baustelleneinrichtung und ein korrespondierendes Computer-Programm Element.

### Hintergrund

Beim Auf-, Um- oder Abbau von Baustelleneinrichtungen müssen aufgrund des hohen Gefahrenpotenzials, insbesondere bei schweren Lasten und großen Höhen, besondere Vorgehensweisen eingehalten werden, um die Sicherheit insbesondere der Personen, die die Baustelleneinrichtung auf-, um- oder abbauen gewährleisten zu können. Darüber hinaus ist sicherzustellen, dass die Baustelleneinrichtung standsicher und funktionstüchtig bereitgestellt wurde. Unter einer solchen Baustelleneinrichtung kann beispielsweise ein Gerüstsystem, beispielsweise ein Fassadengerüst, ein Schalungssystem oder dergleichen verstanden werden.

In diesem Zusammenhang hat sich herausgestellt, dass ein weiterer Bedarf besteht, eine Lösung bereitzustellen, um den Auf-, Um- oder Abbau von Baustelleneinrichtungen möglichst einfach darstellen und überwachen zu können. Insbesondere besteht ein Bedarf, ein digitales real-time Modell einer Baustelleneinrichtung bereitzustellen, insbesondere um dadurch eine Fernüberwachung eines Auf-, Um- oder Abbaus einer Baustelleneinrichtung ermöglichen zu können.

Es ist daher eine Aufgabe der vorliegenden Erfindung eine Lösung bereitzustellen, um den Auf-, Um- oder Abbau von Baustelleneinrichtungen möglichst einfach darstellen und überwachen zu können. Insbesondere ist es eine Aufgabe der vorliegenden Erfindung, ein digitales real-time Modell einer Baustelleneinrichtung bereitzustellen, insbesondere um dadurch eine Fernüberwachung eines Auf-, Um- oder Abbaus einer Baustelleneinrichtung ermöglichen zu können.

Diese und andere Aufgaben, die beim Lesen der folgenden Beschreibung noch genannt werden oder vom Fachmann erkannt werden können, werden durch den Gegenstand der unabhängigen Ansprüche gelöst. Die abhängigen Ansprüche bilden den zentralen Gedanken der vorliegenden Erfindung in besonders vorteilhafter Weise weiter.

### Zusammenfassung der Erfindung

Ein erster Aspekt der vorliegenden Offenbarung betrifft ein computerunterstütztes Verfahren zur Bereitstellung eines digitalen Modells einer Baustelleneinrichtung, insbesondere zur real-time Überwachung der Baustelleneinrichtung, wobei die Baustelleneinrichtung durch Einrichtungselemente aufgebaut wird, umfassend:
Bereitstellen von Sensordaten, umfassend Informationen, die für eine Verwendung eines jeweiligen Einrichtungselements während des Auf-, Ab- oder Umbaus der Baustelleneinrichtung spezifisch sind;
Bereitstellen eines Auswertungsmodells, das eingerichtet ist, um basierend auf den Sensordaten ein digitales Modell der Baustelleneinrichtung bereitzustellen;
Bereitstellen eines digitalen Modells der Baustelleneinrichtung durch Anwendung des Auswertungsmodells und der bereitgestellten Sensordaten.

Unter einer Baustelleneinrichtung im Sinne der vorliegenden Offenbarung kann beispielsweise ein Gerüst, beispielsweise ein Fassadengerüst, ein Schalungssystem oder dergleichen verstanden werden. Der Begriff der Baustelleneinrichtung ist breit zu verstehen und umfasst auch Teilbereiche/- abschnitte derartiger Baustelleneinrichtungen. Baustelleneinrichtungen im Sinne der vorliegenden Offenbarung zeichnen sich insbesondere dadurch aus, dass diese durch eine Vielzahl von Einrichtungselementen, beispielsweise Gerüstbauteile, in einem Baustellenumfeld auf-, um- oder abgebaut werden. Derartige Baustelleneinrichtungen können dabei flexibel an eine jeweilige Baustellensituation bzw. flexibel an aktuelle Arbeitsabschnitte angepasst werden. In der Praxis kommt es regelmäßig vor, dass nicht mehr notwendiger Gerüstabschnitt eines Gerüstes abgebaut wird, während zeitgleich an anderer Stelle ein neuer Gerüstabschnitt aufgebaut wird.

Eine der vorliegenden Offenbarung zugrundeliegende Erkenntnis ist es, dass Einrichtungselemente einer Baustelleneinrichtung während des Auf-, Um- oder Abbaus aufgrund eindeutig zuordenbaren Sensorcharakteristiken identifizierbar sind, und zwar hinsichtlich ihrer Verwendung als solche, als auch hinsichtlich der Position in der Baustelleneinrichtung. Wird beispielsweise ein Horizontalriegel eines Gerüstes eingebaut, der beispielsweise mittels eines Sicherungs-/Hammerschlages auf einen Sicherungskeil abschließend befestigt/gesichert wird, ergibt sich dadurch ein charakteristisches Akustikprofil für den Einbau oder Ausbau eines solchen Horizontalriegels. Beispielsweise kann durch eine weitere Analyse auch ermittelt werden, in welcher Entfernung der Horizontalregel von einem korrespondierenden Akustiksensor eingebaut wurde, sodass ebenfalls ein Rückschluss auf die Einbauposition des Horizontalriegels möglich ist. Somit kann beispielsweise durch die Auswertung des während des Ein- oder Ausbaus emittierten Schalls auf den Ein- oder Ausbau eines bestimmten Einrichtungselements geschlossen werden und auch auf dessen Position. Grundsätzlich besteht daher die Möglichkeit, sowohl den Einsatz eines bestimmten Einrichtungselements in der Baustelleneinrichtung, als auch die Position des Einrichtungselements in der Baustelleneinrichtung aus der Analyse/Auswertung einer Sensorcharakteristik durch das Auswertungsmodell zu bestimmen. Je nach Einrichtungselement bzw. je nach konkretem Einsatz des Einrichtungselements kann es einfacher bzw. zur Sicherheit auch notwendig sein, mehrere Sensorcharakteristiken auszuwerten, um die Verwendung eines jeweiligen Einrichtungselements, als auch dessen Position in der Baustelleneinrichtung sicher feststellen zu können.

Die vorliegende Offenbarung erlaubt somit eine real-time Überwachung einer Baustelleneinrichtung während des Auf-, Um- oder Abbaus durch die Analyse von Sensordaten. Es können beispielsweise an einer Baustelle verschiedene Sensoren zur Erfassung der Sensordaten vorgesehen sein, diese Sensordaten können anschließend insbesondere an eine zentrale Recheneinheit übermittelt werden, auf der das Auswertungsmodell gespeichert und ausgeführt wird. Die Sensordaten können beispielsweise in real-time an die zentrale Recheneinheit übermittelt werden, sodass der aktuelle Zustand der Baustelleneinrichtung bzw. der jeweiligen Einrichtungselemente ebenfalls in real-time als digitales Modell bereitgestellt werden kann. Die Sensoren können ortsfest an der Baustelleneinrichtung vorgesehen/installiert sein oder beispielsweise auch durch Bedienpersonen bewegt werden oder an diesen angebracht sein. Das Auswertungsmodell hat darüber hinaus Zugriff auf die Objektdaten der Einrichtungselemente bzw. der Baustelleneinrichtung. Diese Objektdaten umfassen dabei zumindest Informationen über die in einer jeweiligen Baustelleneinrichtung grundsätzlich einsetzbaren Einrichtungselemente. Beispielsweise können darüber hinaus in den Objektdaten der Einrichtungselemente bzw. der Baustelleneinrichtung auch Geometriedaten dieser umfasst sein, sodass das Auswertungsmodell auf diese Objektdaten zurückgreifen kann bei der Bereitstellung des digitalen Modells der Baustelleneinrichtung.

Basierend auf diesem digitalen Modell besteht die Möglichkeit, den Auf-, Um- oder Abbau der Baustelleneinrichtung zu überwachen. Dabei können Abweichungen von einer vorgegebenen Vorgehensweise während des Auf-, Um- oder Abbaus der Baustelleneinrichtung und/oder von einer vorgegebenen Positionierung eines jeweiligen Einrichtungselements festgestellt werden. Dies kann beispielsweise durch den Einsatz eines Analyse- und/oder Überwachungsmodells erfolgen. Ein solches Analyse- und/oder Überwachungsmodell kann beispielsweise als trainierter Algorithmus bereitgestellt werden. Sollte durch das Analyse- und/oder Überwachungsmodell eine Abweichung festgestellt werden, können automatisiert Kontroll-, Alarm- und/oder Instruktionsdaten generiert und an vorbestimmte Geräte/Adressaten übermittelt werden. Sollte beispielsweise durch das Analyse- und/oder Überwachungsmodell festgestellt werden, dass ein Einrichtungselement fehlerhaft eingebaut wurde, kann eine Mitteilung an eine Bedien- oder Aufsichtsperson übermittelt werden und diese angewiesen werden, dieses spezielle Einrichtungselement zu überprüfen. Soweit beispielsweise das übermittelte Akustikprofil für den Einbau eines Horizontalriegels nur einen Sicherungsschlag/Hammerschlag umfasst, kann von einem fehlerhaften Einbau dieses Horizontalriegels ausgegangen werden, wenn für den Einbau eines solchen Horizontalriegels zwei Sicherungsschläge/Hammerschläge vorgesehen sind.

Der Begriff des "Einrichtungselements" ist vorliegend breit zu verstehen und umfasst alle Bauteile/Elemente, die für den Auf-, Um- oder Abbau einer Baustelleneinrichtung verwendet werden bzw. eingesetzt werden können. Unter dem Begriff "Verwendung eines Einrichtungselements" ist vorliegend zum einen der Einsatz eines Einrichtungselements als solches zu verstehen, als auch die Positionierung des Einrichtungselements in der Baustelleneinrichtung. Durch das Auswertungsmodell soll somit nicht nur ermittelt werden können, dass ein bestimmtes Einrichtungselement eingesetzt wurde, sondern auch wo das Einrichtungselement in der Baustelleneinrichtung eingesetzt wurde.

Der Begriff "real-time" ist vorliegend breit zu verstehen und umfasst einen Zeitraum bis zu 60 Minuten, vorzugsweise einen Zeitraum bis zu 30 Minuten und besonders bevorzugt einen Zeitraum bis zu 15 Minuten. Der angegebene Zeitraum bemisst sich dabei vom tatsächlichen Ein-, Um- oder Abbau eines Einrichtungselements bis zur korrespondierenden Anpassung des digitalen Modells.

Der Begriff "Bereitstellen" ist vorliegend breit zu verstehen und steht für jegliches Bereitstellen, Empfangen, Abfragen, Messen, Berechnen, Bestimmen, Übertragen von Daten, ist hierauf allerdings nicht beschränkt. Daten können von einem Benutzer über eine Benutzerschnittstelle bereitgestellt, einem Benutzer über ein Display dargestellt/angezeigt und/oder von anderen Geräten empfangen, von anderen Geräten abgefragt, von anderen Geräten gemessen, von anderen Geräten berechnet, von anderen Geräten bestimmt und/oder von anderen Geräten übertragen werden.

Der Begriff "Daten" ist vorliegend breit zu verstehen und steht für jede Art von digitalen Daten. Daten können einzelne Zahlen/Zahlenwerte, eine Vielzahl von Zahlen/Zahlenwerten, eine Vielzahl von Zahlen/Zahlenwerten, die in einer Liste angeordnet sind, zweidimensionale Karten oder dreidimensionale Karten umfassen. Der Begriff "Daten" ist hierauf allerdings nicht beschränkt. Die Daten können ferner auch in unterschiedlichen Formaten bereitgestellt werden.

In einer Ausführungsform umfassen die Sensordaten zumindest eine der nachfolgenden Sensordaten:
- Akustikdaten, die während des Ein-, Um- oder Ausbaus zumindest eines Einrichtungselements erfasst wurden und die die beim Ein-, Um- oder Ausbau eines Einrichtungselements auftretenden Geräusche umfasst;
- Bilddaten, die während des Ein-, Um- oder Ausbaus zumindest eines Einrichtungselements erfasst wurden und die dieses Einrichtungselement umfassen;
- Videodaten, die während des Ein-, Um- oder Ausbaus zumindest eines Einrichtungselements erfasst wurden und die dieses Einrichtungselement umfassen;
- Positionsdaten, die während des Ein-, Um- oder Ausbaus zumindest eines Einrichtungselements erfasst wurden und die zumindest eine Position eines Einrichtungselements, einer Bedienperson und/oder einer weiteren Einrichtung während des Ein-, Um- oder Ausbaus des Einrichtungselements umfassen;
- Bewegungsdaten, die während des Ein-, Um- oder Ausbaus zumindest eines Einrichtungselements erfasst wurden und die zumindest eine Bewegung eines Einrichtungselements, einer Bedienperson und/oder einer weiteren Einrichtung während des Ein-, Um- oder Ausbaus des Einrichtungselements zeigen;
- Beschleunigungsdaten, die während des Ein-, Um- oder Ausbaus zumindest eines Einrichtungselements erfasst wurden und die zumindest eine Beschleunigung eines Einrichtungselements, einer Bedienperson und/oder einer weiteren Einrichtung während des Ein-, Um- oder Ausbaus des Einrichtungselements umfassen;
- Schwingungsdaten, die während des Ein-, Um- oder Ausbaus zumindest eines Einrichtungselements erfasst wurden und die zumindest eine mechanische Schwingung eines Einrichtungselements und/oder einer weiteren Einrichtung während des Ein-, Um- oder Ausbaus des Einrichtungselements umfassen;
- Gewichtsdaten, die während des Ein-, Um- oder Ausbaus zumindest eines Einrichtungselements erfasst wurden und die zumindest ein Gewicht eines Einrichtungselements, einer Bedienperson und/oder einer weiteren Einrichtung während des Ein-, Um- oder Ausbaus des Einrichtungselements umfassen; und/oder
- Last- und/oder Dehnungsdaten, die während des Ein-, Um- oder Ausbaus zumindest eines Einrichtungselements erfasst wurden und die durch zumindest einen Dehnungsaufnehmer bereitgestellt wurden, der an einem Einrichtungselement, einer Bedienperson und/oder einer weiteren Einrichtung während des Ein-, Um- oder Ausbaus des Einrichtungselements angeordnet ist.

Als weitere Einrichtungen, die während des Auf-, Um- oder Abbaus erfasst werden können bzw. deren korrespondierenden Sensordaten verarbeitet werden können, können beispielsweise Gerüstlifte, Transportmittel, Lagermittel und dergleichen verstanden werden. Insbesondere können unter derartigen weiteren Einrichtungen auch nicht stationäre Einrichtungen verstanden werden, die lediglich temporär an der Baustelleneinrichtung vorgesehen sind.

In einer Ausführungsform werden die Positionsdaten unter Einsatz zumindest einer der nachfolgenden Einrichtungen bereitgestellt:
- eine satellitenbasierte Positionserfassungseinrichtung, wobei zumindest eine satellitenbasierte Positionserfassungseinrichtung an einem Einrichtungselement, einer Bedienperson und/oder an einer weiteren Baute angeordnet ist;
- eine Sende-Empfangseinheit, wobei zumindest eine Sende-Empfangseinheit an einem Einrichtungselement angeordnet ist;
- eine Sende-Empfangseinheit, wobei zumindest eine Sende-Empfangseinheit an einer Bedienperson angeordnet ist; und/oder
- eine Sende-Empfangseinheit, wobei zumindest eine Sende-Empfangseinheit an einer weiteren Einrichtung angeordnet ist.

In einer Ausführungsform umfasst das Auswertungsmodell zumindest eine Datenbank, in der für die Verwendung eines jeweiligen Einrichtungselements zumindest eine spezifische (Sensor-)Charakteristik hinterlegt ist. Eine solche spezifische Charakteristik kann beispielsweise folgendes umfassen:
- ein Akustikprofil, das die beim Ein-, Um- oder Ausbau eines Einrichtungselements auftretenden Geräuschmuster eines Einrichtungselements, einer Bedienperson und/oder einer sonstigen Einrichtung abbildet;
- ein Bewegungsprofil, das die beim Ein-, Um- oder Ausbau eines Einrichtungselements auftretenden Bewegungsmuster eines Einrichtungselements, einer Bedienperson und/oder einer sonstigen Einrichtung abbildet;
- ein Beschleunigungsprofil, das die beim Ein-, Um- oder Ausbau eines Einrichtungselements auftretenden Beschleunigungsmuster eines Einrichtungselements, einer Bedienperson und/oder einer sonstigen Einrichtung abbildet;
- ein Schwingungsprofil, das die beim Ein-, Um- oder Ausbau eines Einrichtungselements auftretenden Schwingungsmuster eines Einrichtungselements, einer Bedienperson und/oder einer sonstigen Einrichtung abbildet;
- ein Gewicht und/oder eine Gewichtsverteilung, das das beim Ein-, Um- oder Ausbau eines Einrichtungselements auftretende Gewicht und/oder Gewichtsverteilung eines Einrichtungselements, einer Bedienperson und/oder einer sonstigen Einrichtung abbildet;
- eine Last- und/oder Dehnungsprofil, das die während des Ein-, Um- oder Ausbau auftretende Last- und/oder Dehnungsverteilung eines Einrichtungselements, einer Bedienperson und/oder einer sonstigen Einrichtung abbildet.

In einer Ausführungsform werden mehrere spezifische Charakteristiken ausgewertet, um eine sichere Zuordnung eines spezifischen Einrichtungselements im digitalen Modell der Baustelleneinrichtung vorzunehmen. Beispielsweise können für die Bestimmung, um welches Einrichtungselement es sich handelt, Akustikdaten ausgewertet werden und für die Bestimmung der konkreten Einbauposition des Einrichtungselements in der Baustelleneinrichtung können zudem Positionsdaten und/oder Videodaten ausgewertet werden.

In einer Ausführungsform umfasst das Auswertungsmodell zumindest einen trainierten Algorithmus, der eingerichtet ist, basierend auf den Sensordaten das digitale Modell der Baustelleneinrichtung bereitzustellen. Der hier verwendete Begriff "trainierter Algorithmus" ist dabei breit zu verstehen. Der Algorithmus kann ein maschineller Lernalgorithmus sein. Der Algorithmus kann Entscheidungsbäume, Naive-Bayes-Klassifizierungen, "Nearest Neighbors", neuronale Netze, Faltungsnetze oder rekurrente neuronale Netze, Transformatoren, generative adversarische Netze, Support Vector Machines, lineare Regression, logistische Regression, Random Forest, Gradient-Boosting-Algorithmen und/oder ein Diffusionsmodell umfassen. Ein solcher Algorithmus, insbesondere ein maschineller Lernalgorithmus, wird als "intelligent" bezeichnet, weil er "trainiert" werden kann. Der Algorithmus kann anhand von Trainingsdatensätzen trainiert werden. Ein Trainingsdatensatz umfasst Trainingseingangsdaten und entsprechende Trainingsausgangsdaten. Im Rahmen der vorliegenden Offenbarung können die Trainingsdaten beispielsweise ein Sensordaten und mindestens eine Zuordnung eines korrespondierenden Einrichtungselements umfassen. Bei den Sensordaten kann es sich um die Trainings-Eingangsdaten handeln. Bei den Einrichtungselementen kann es sich um die Trainingsausgangsdaten handeln. Die Trainingsausgangsdaten eines Trainingsdatensatzes sind das Ergebnis, das vom Algorithmus erwartet wird, wenn er die Trainingseingangsdaten desselben Trainingsdatensatzes als Eingabe erhält. Die Abweichung zwischen diesem erwarteten Ergebnis und dem vom Algorithmus tatsächlich erzielten Ergebnis wird beobachtet und beispielsweise mit Hilfe einer "Verlustfunktion" bewertet. Diese Verlustfunktion wird als Feedback für die Anpassung der Parameter der internen Verarbeitungskette des Algorithmus verwendet. Beispielsweise können die Parameter mit dem Optimierungsziel angepasst werden, die Werte der Verlustfunktion zu minimieren, die sich ergeben, wenn alle Trainings-Eingangsdaten in den Algorithmus eingespeist werden und das Ergebnis mit den entsprechenden Trainings-Ausgangsdaten verglichen wird. Das Ergebnis dieses Trainings ist, dass der Algorithmus bei einer relativ kleinen Anzahl von Trainingsdatensätzen als "Grundwahrheit" ("ground truth") in der Lage ist, seine Aufgabe bei einer um viele Größenordnungen höheren Anzahl von Eingabedatensätzen gut zu erfüllen.

In einer Ausführungsform ist das Auswertungsmodell eingerichtet, das digitale Modell der Baustelleneinrichtung basierend auf den Positionsdaten in Kombination mit weiteren Sensordaten bereitzustellen.

In einer Ausführungsform ist die Baustelleneinrichtung ein Gerüstsystem, umfassend zumindest die folgenden Einrichtungselemente: Rahmenelemente, Stielelemente, Querriegel, Horizontalriegel, Diagonalen, Belagelemente, Längsriegel. Für diese Einrichtungselemente können beispielsweise unterschiedliche spezifische Sensordaten erfasst werden und in einer Datenbank hinterlegt werden, auf die das Auswertungsmodell zur Analyse zugreifen kann. Zusätzlich oder alternativ das Auswertungsmodell als trainierter Algorithmus bereitgestellt werden, der mit unterschiedlichen spezifischen Sensordaten trainiert wurde. Beispielsweise kann das Auswertungsmodell in der Ausgestaltung als trainierter Algorithmus mit unterschiedlichen Sensordaten trainiert werden, um ein jeweiliges Einrichtungselement und dessen Position zu bestimmen. Ein solcher Algorithmus kann beispielsweise mit Akustikdaten, Videodaten, Bilddaten, Beschleunigungsdaten, Gewichtsdaten, Schwingungsdaten und/oder Kombinationen hiervon trainiert werden.

In einer Ausführungsform hat das Auswertungsmodell Zugriff auf die Information über die Anzahl der in der Baustelleneinrichtung vorgesehenen Einrichtungselemente, wobei diese Information beim Bereitstellen des digitalen Modells verarbeitet wird. Beispielsweise kann vordefiniert/vorgegeben sein, dass in einem Gerüstsystem eine bestimmte Anzahl von Horizontalriegel vorgesehen sind, sodass dies durch das Auswertungsmodell berücksichtigt werden kann. Dadurch besteht die Möglichkeit, die notwendige Rechenleistung zu reduzieren, da durch eine derartige Vorgabe die potentiellen Alternativen, um welches Einrichtungselement es sich handelt, erheblich reduziert werden können.

In einer Ausführungsform umfasst das computerunterstützte Verfahren weiterhin:
Bereitstellen eines digitalen Planungsmodells der Baustelleneinrichtung;
Ausgabe von Differenzdaten, durch einen Datenvergleich des digitalen Modells der Baustelleneinrichtung und des digitalen Planungsmodells der Baustelleneinrichtung. Durch die Ausgabe derartiger Differenzdaten, die die Abweichungen einer geplanten Ausgestaltung der Baustelleneinrichtung zu einer tatsächlichen Ausgestaltung der Baustelleneinrichtung bereitstellt, kann vergleichsweise schnell ermittelt werden, ob die abweichend bereitgestellte Baustelleneinrichtung weiterhin standsicher und funktionstüchtig ist, da vergleichsweise schnell ermittelt werden kann, ob die Abweichungen für die Standsicherheit und Funktionssicherheit von Bedeutung bzw. von wesentlicher Bedeutung sind. Auch zur Bereitstellung der Differenzdaten kann beispielsweise ein trainierter Algorithmus eingesetzt werden bzw. besteht die Möglichkeit, das Analyse- und/oder Überwachungsmodell entsprechend heranzuziehen bzw. zu erweitern.

In einer Ausführungsform werden basierend auf dem digitalen Modell Instruktionsdaten für zumindest eine Bedienperson ausgegeben, wobei die Instruktionsdaten auf einem vorgegebenen Auf-, Ab-, oder Umbauablauf der Baustelleneinrichtung und/oder einem vorgegebenen Auf-, Ab-, oder Umbauablauf für ein Einrichtungselement basieren. Hierbei können beispielsweise existierende Ausführungsordnungen, Normen, etc. herangezogen werden. In einer Ausführungsform werden basierend auf dem digitalen Modell Validierungsdaten ausgegeben, wobei die Validierungsdaten auf einem vorgegebenen Auf-, Ab-, oder Umbauablauf der Baustelleneinrichtung und/oder einem vorgegebenen Auf-, Ab-, oder Umbauablauf für ein Einrichtungselement basieren. Der Begriff der Validierungsdaten ist vorliegend breit zu verstehen und umfasst insbesondere Daten, die die Einhaltung der entsprechenden Vorgaben beim Auf-, Ab-, oder Umbau der Baustelleneinrichtung und/oder des Einrichtungselements erfasst bzw. bestätigt. Diesbezüglich können entsprechende Maßnahmen getroffen werden, um eine nachträgliche Veränderung der Validierungsdaten zu verhindern. Beispielsweise können hier Blockchain-Anwendungen eingesetzt werden. In einer Ausführungsform werden basierend auf dem digitalen Modell Materialsteuerdaten ausgegeben, wobei die Materialsteuerdaten auf einem vorgegebenen Auf-, Ab-, oder Umbauablauf der Baustelleneinrichtung und/oder einem vorgegebenen Auf-, Ab-, oder Umbauablauf für ein Einrichtungselement basieren. Der Begriff Materialsteuerdaten ist vorliegend breit zu verstehen und umfasst insbesondere Daten hinsichtlich der Materialströme am, zum oder in der Baustelleneinrichtung. Beispielsweise kann hierdurch Material für bestimmte Positionen an oder in der Baustelleneinrichtung angefordert werden.

In einer Ausführungsform werden in einem ersten Schritt die Sensordaten für den Auf-, Ab-, oder Umbau der Baustelleneinrichtung erfasst und bereitgestellt und in einem zweiten Schritt wird das digitale Modell der Baustelleneinrichtung durch Anwendung des Auswertungsmodells und der Sensordaten bereitgestellt.

In einer Ausführungsform wird das digitale Modell der Baustelleneinrichtung als maschinenlesbares Format, beispielsweise im "JavaScript Object Notation (JSON)" oder im "Extensible Markup Language (xml)" Format bereitgestellt. Die Bereitstellung des digitalen Modells ist dabei nicht auf eine 3D Repräsentation beschränkt. Vielmehr kann das digitale Modell in beliebigen Datenformaten bereitgestellt werden.

Ein weiterer Aspekt der vorliegenden Offenbarung betrifft ein System zur Bereitstellung eines digitalen Modells einer Baustelleneinrichtung, insbesondere zur real-time Überwachung der Baustelleneinrichtung, wobei die Baustelleneinrichtung durch Einrichtungselemente aufgebaut wird, umfassend:
eine erste Bereitstellungseinrichtung, eingerichtet zum Bereitstellen von Sensordaten, umfassend Informationen, die für eine Verwendung eines jeweiligen Einrichtungselements während des Auf-, Um- oder Abbaus der Baustelleneinrichtung spezifisch sind;
eine zweite Bereitstellungseinrichtung, eingerichtet zum Bereitstellen eines Auswertungsmodells, das eingerichtet ist, um basierend auf den Sensordaten das digitale Modell der Baustelleneinrichtung während des Auf-, Um- oder Abbaus der Baustelleneinrichtung bereitzustellen;
eine dritte Bereitstellungseinrichtung, eingerichtet zum Bereitstellen eines digitalen Modells der Baustelleneinrichtung durch Anwendung des Auswertungsmodells und der bereitgestellten Sensordaten.

Ein weiterer Aspekt der vorliegenden Offenbarung betrifft ein System zur Bereitstellung eines digitalen Modells einer Baustelleneinrichtung, insbesondere zur real-time Überwachung der Baustelleneinrichtung, umfassend:
eine Verarbeitungsschaltung;
ein Speichermedium; und
eine Datenschnittstelle;
wobei das Speichermedium ein Computerprogramm umfasst, das Anweisungen enthält, die, wenn das Computerprogramm ausgeführt wird, die Verarbeitungsschaltung veranlasst, das oben beschriebene Verfahren auszuführen;
wobei die Datenschnittstelle so konfiguriert ist, dass sie Sensordaten, und das Auswertungsmodell empfängt.

Ein weiterer Aspekt der vorliegenden Offenbarung betrifft eine Vorrichtung zum Bereitstellung eines digitalen Modells einer Baustelleneinrichtung, insbesondere zur real-time Überwachung der Baustelleneinrichtung, wobei die Baustelleneinrichtung durch Einrichtungselemente aufgebaut wird, wobei die Vorrichtung umfasst: einen oder mehrere Rechnerknoten und ein oder mehrere computerlesbare Medien mit darauf befindlichen computerausführbaren Anweisungen, die so ausgestaltet sind, dass sie, wenn sie von dem einen oder den mehreren Rechnerknoten ausgeführt werden, die Vorrichtung veranlassen, die folgenden Schritte durchzuführen:
Bereitstellen von Sensordaten, umfassend Informationen, die für eine Verwendung eines jeweiligen Einrichtungselements während des Auf-, Ab- oder Umbaus der Baustelleneinrichtung spezifisch sind;
Bereitstellen eines Auswertungsmodells, das eingerichtet ist, um basierend auf den Sensordaten das digitale Modell der Baustelleneinrichtung bereitzustellen;
Bereitstellen eines digitalen Modells der Baustelleneinrichtung durch Anwendung des Auswertungsmodells und der bereitgestellten Sensordaten.

Ein weiterer Aspekt der vorliegenden Offenbarung betrifft eine Verwendung von Sensordaten und/oder eines Auswertungsmodells in einem oben beschriebenen Verfahren und/oder in einem oben beschriebenen System zur Bereitstellung eines digitalen Models einer Baustelleneinrichtung.

Ein weiterer Aspekt der vorliegenden Offenbarung betrifft ein Computer-Programm Element umfassend Anweisungen, die bei Ausführung auf Computergeräten einer Computerumgebung konfiguriert sind, die Schritte des oben beschriebenen in einem oben beschriebenen System auszuführen.

Einzelne Merkmale und Ausführungsformen der vorliegenden Erfindung können mit anderen Merkmalen in anderen Ausführungsform kombiniert werden und so neue Ausführungsformen bilden. Vorteile und Weiterbildungen, die für die Merkmale oder Ausführungsformen genannt sind, gelten analog auch für die neuen Ausführungsformen. Weiterbildungen und Vorteile, die in Zusammenhang mit der Vorrichtung genannt sind, gelten analog auch für das Verfahren und andersherum.

### Beschreibung einer bevorzugten Ausführungsform

Weitere Merkmale, Vorteile und Anwendungsmöglichkeiten der vorliegenden Erfindung ergeben sich aus der nachfolgenden Beschreibung, dem Ausführungsbeispiel und den Figuren. Darin zeigen:
- **Figur 1**: ein Ausführungsbeispiel eines erfindungsgemäßen Verfahrens;
- **Figur 2**: ein Ausführungsbeispiel eines erfindungsgemäßen Systems;
- **Figur 3**: zeigt eine Baustelleneinrichtung in Form eines Gerüstsystems;
- **Figur 4**: einen ersten vergrößerten Ausschnitt eines Bereichs des in Figur 3 gezeigten Gerüstsystems;
- **Figur 5**: einen zweiten vergrößerten Ausschnitt eines Bereichs des in Figur 3 gezeigten Gerüstsystems; und
- **Figur 6**: einen dritten vergrößerten Ausschnitt eines Bereichs des in Figur 3 gezeigten Gerüstsystems.

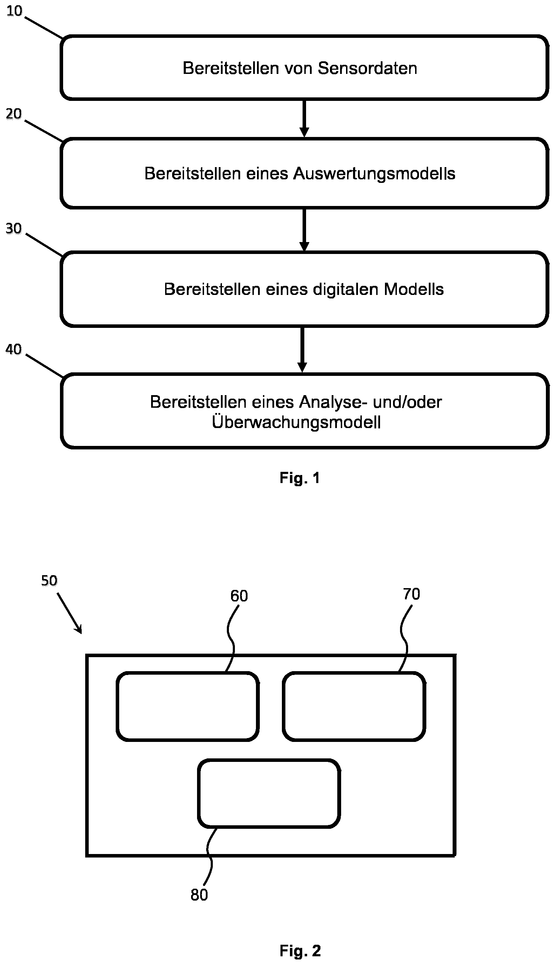

**Figur 1** zeigt ein computerunterstütztes Verfahren zur Bereitstellung eines digitalen Modells einer Baustelleneinrichtung, insbesondere zur real-time Überwachung der Baustelleneinrichtung, wobei die Baustelleneinrichtung durch Einrichtungselemente aufgebaut wird.

In einem ersten Schritt 10 werden Sensordaten bereitgestellt, wobei die Sensordaten Informationen umfassen, die für eine Verwendung eines bestimmten Einrichtungselements während des Auf-, Ab- oder Umbaus der Baustelleneinrichtung spezifisch sind. Die Sensordaten können dabei Daten umfassen, die während des Ein-, Um- oder Ausbaus eines Einrichtungselemente erfasst wurden. Insbesondere kann es sich bei den Sensordaten um korrespondierende Akustikdaten, Bilddaten, Videodaten, Positionsdaten, Bewegungsdaten, Beschleunigungsdaten, Schwingungsdaten, Gewichtsdaten, Last- und/oder Dehnungsdaten handeln.

In einem zweiten Schritt 20 wird ein Auswertungsmodell bereitgestellt, das eingerichtet ist, um basierend auf den Sensordaten ein digitales Modell der Baustelleneinrichtung bereitzustellen. Das Auswertungsmodell kann beispielsweise datenbankbasiert ausgebildet sein und/oder einen auf die Einrichtungselemente und die Sensordaten trainierten Algorithmus umfassen. Das Auswertungsmodell kann dabei die Sensordaten als Eingangsdaten verarbeiten und als Ausgangsdaten angeben, um welches Einrichtungselemente es sich handelt und auf welcher Position das Einrichtungselemente in der Baustelleneinrichtung angeordnet ist.

In einem dritten Schritt 30 wird ein digitales Modell der Baustelleneinrichtung durch Anwendung des Auswertungsmodells und der bereitgestellten Sensordaten bereitgestellt. Das digitale Modell wird dabei vorzugsweise in real-time bereitgestellt bzw. aktualisiert, sodass eine real-time Überwachung der Baustelleneinrichtung während des Auf-, Um- oder Abbaus möglich ist. Es können beispielsweise an einer Baustelle verschiedene Sensoren zur Erfassung der Sensordaten vorgesehen sein, diese Sensordaten können anschließend insbesondere an eine zentrale Recheneinheit übermittelt werden, auf der das Auswertungsmodell gespeichert und ausgeführt wird. Die Sensordaten können dabei beispielsweise in real-time an die zentrale Recheneinheit übermittelt werden, sodass der aktuelle Zustand der Baustelleneinrichtung bzw. der jeweiligen Einrichtungselemente ebenfalls in real-time als digitales Modell bereitgestellt werden kann.

In einem optionalen vierten Schritt 40 kann ein Analyse- und/oder Überwachungsmodell bereitgestellt werden, das eingerichtet ist, um Abweichungen von einer vorgegebenen Verwendung des Einrichtungselements und einer Verwendung während des Auf-, Ab- oder Umbaus der Baustelleneinrichtung zu erfassen. Darüber hinaus besteht die Möglichkeit, Kontroll-, Alarm- und/oder Instruktionsdaten bei Erfassung einer Abweichung zu generieren. Diese Daten können anschließend beispielsweise an einen vordefinierten Geräte-Empfängerkreis übermittelt werden. Wenn beispielsweise festgestellt wird, dass ein Einrichtungselement fehlerhaft eingebaut wurde, kann eine entsprechende Mitteilung an eine Aufsichtsperson und/oder an eine Bedienperson übermittelt werden.

**Figur 2** zeigt ein System 50 zur Bereitstellung eines digitalen Modells einer Baustelleneinrichtung, insbesondere zur real-time Überwachung der Baustelleneinrichtung. Das System 50 umfasst und dabei eine Verarbeitungsschaltung 60, ein Speichermedium 70 und eine Datenschnittstelle 80. das Speichermedium 70 umfasst ein Computerprogramm, das Anweisungen enthält, die, wenn das Computerprogramm ausgeführt wird, die Verarbeitungsschaltung 60 veranlasst, ein Verfahren zur Bereitstellung eines digitalen Modells einer Baustelleneinrichtung auszuführen. Die Datenschnittstelle 80 ist dabei derart konfiguriert, dass diese die Sensordaten und das Auswertungsmodell empfangen können.

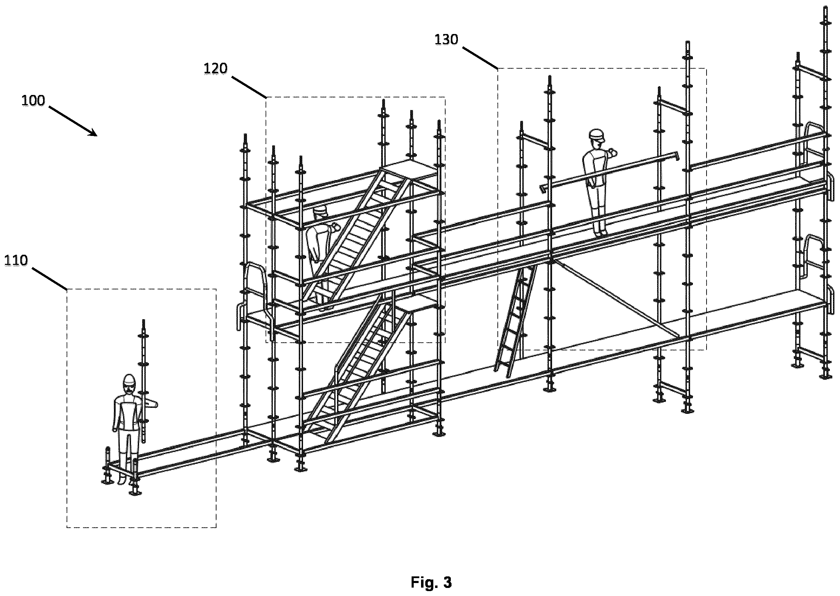

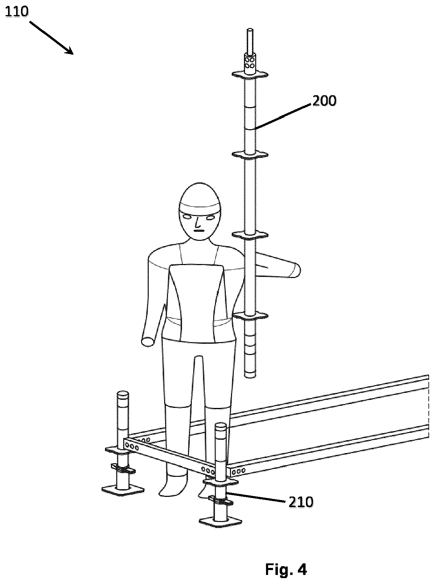

**Figur 3** zeigt eine Baustelleneinrichtung 100 in Form eines Gerüstsystems 100. Wie in **Figur 3** gut zu erkennen ist, führen Bedienpersonen an unterschiedlichen Stellen Tätigkeiten am Gerüstsystem 100 aus. Diese Bereiche sind mit den Bezugszeichen 110, 120 und 130 gekennzeichnet und in den Figuren 4 bis 6 nochmals vergrößert dargestellt.

Wie in **Figur 4** zu erkennen ist, wird im Bereich 110 ein Vertikalstielelement 200 auf eine sogenannte Gerüstspindel/Fußspindel 210 durch die Bedienperson angeordnet. Als Sensordaten, durch die die Verwendung des Vertikalstielelements 200 durch das Auswertungsmodell bestimmt werden kann, können vorliegend unterschiedliche Sensoren bzw. Sensordaten herangezogen werden. Beispielsweise könnte in der Gerüstspindel 210 ein Gewichtssensor angeordnet sein, der das auf die Gerüstspindel 210 aufgebrachte Gewicht bestimmt und als Sensordaten bereitstellt. Im Auswertungsmodell könnten in einem solchen Fall die Gewichte der jeweiligen Einrichtungselemente, hier beispielsweise die Bauteile des Gerüstsystems 100, hinterlegt sein, sodass aufgrund des erfassten Gewichts darauf geschlossen werden kann, dass es sich bei dem auf der Gerüstspindel 210 angeordneten Einrichtungselement um das Vertikalstilelement 200 handelt. Dadurch kann im digitalen Modell des Gerüstsystems 100 das Vertikalstilelement 200 auf der Gerüstspindel 210 hinzugefügt werden. Alternativ oder zusätzlich können weitere Sensoren bzw. Sensordaten eingesetzt werden. Beispielsweise könnten die Bewegungen der Bedienperson durch ein Kamerasystem erfasst werden, wobei in einem solchen Fall das Auswertungsmodell eingerichtet ist, um die Bewegungen der Bedienperson auszuwerten und dadurch auf das eingesetzte Einrichtungselemente zu schließen. Die vorliegende Offenbarung ist dabei nicht auf die Erfassung bzw. Auswertung bestimmter Sensordaten beschränkt.

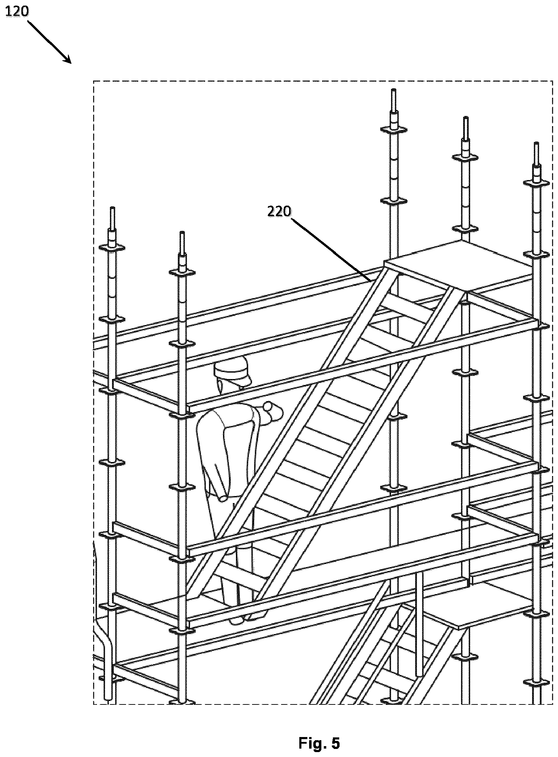

**Figur 5** zeigt den Bereich 120 aus **Figur 3****.** In diesem Bereich wird beispielsweise ein Leitermodul 220 durch eine Bedienperson im Gerüstsystem 100 angeordnet. Zur Erfassung des Leitermoduls 220, also der Information, dass das Leitermodul 220 im Gerüstsystem 100 eingesetzt wird und wo das Leitermodul 220 im Gerüstsystem 100 eingesetzt wird, können auch hier unterschiedliche Sensoren und Sensordaten eingesetzt werden. Beispielsweise könnten Schwingungsdaten durch das Auswertungsmodell ausgewertet werden, die von Schwingungsaufnehmern bereitgestellt werden, die an unterschiedlichen Positionen im Gerüstsystem 100 angeordnet sind. Den durch den Einbau des Leitermoduls 220 kann ein für das Leitermodul 220 spezifisches Schwingungsmuster erfasst und ausgewertet werden. Auch bei diesem Beispiel können weitere Sensordaten erfasst und ausgewertet werden.

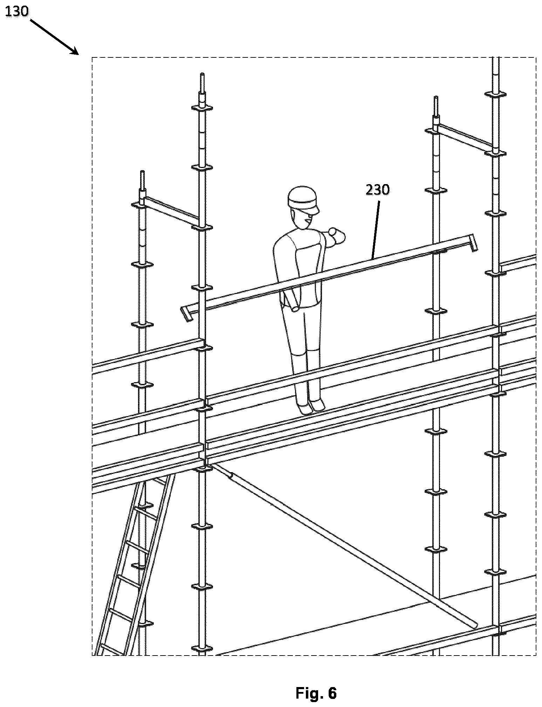

**Figur 6** zeigt den Bereich 130 aus **Figur 3****.** In diesem Bereich wird ein Horizontalriegel 230 durch eine Bedienperson im Gerüstsystem 100 angeordnet. Zur Erfassung des Horizontalriegels 230 könnten beispielsweise Akustikdaten erfasst und durch das Auswertungsmodell ausgewertet werden. Denn die Anordnung des Horizontalriegels 230 geht mit einem spezifischen Akustikmuster einher, durch das Auswertungsmodell auf die Verwendung des Horizontalriegels 230 schließen kann.

Sollte während des Einbaus der in den **Figuren 4 bis 6** gezeigten Einrichtungselemente 200, 210, 230 durch das Analyse- und/oder Überwachungsmodell ein fehlerhafter Einbau, also eine Abweichung von einer vorgegebenen Verwendung des jeweiligen Einrichtungselements, können korrespondierende Kontroll-, Alarm- und/oder Instruktionsdaten generiert werden und beispielsweise an eine oder mehrere Mobilgeräte der Bedienpersonen übermittelt werden.

Ferner besteht die Möglichkeit, basierend auf dem digitalen Modell Materialsteuerdaten zu generieren, um dadurch den Aufbau des Gerüstsystems 100 zu vereinfachen. Beispielsweise können dadurch Steuerdaten generiert werden, um Einrichtungselemente an eine bestimmte Position im Gerüstsystem 100 zu transportieren.

Nach dem Aufbau des Gerüstsystems 100 können darüber hinaus beispielsweise Validierungsdaten generiert werden. Durch solche Validierungsdaten kann beispielsweise bestätigt werden, dass keine Abweichung von einem vorgegebenen Aufbauablauf der Baustelleneinrichtung vorliegen. Diese Validierungsdaten können beispielsweise durch eine Blockchain vor Manipulation gesichert werden.

Andere Ausführungsformen der vorliegenden Erfindung sind möglich und können von Fachpersonen bei der Anwendung des beanspruchten Gegenstands aus dem Studium der Figuren, der Offenbarung und der beigefügten Ansprüche verstanden und ausgeführt werden. Insbesondere können die jeweiligen Teile/Funktionen des jeweiligen oben beschriebenen Ausführungsform auch miteinander kombiniert werden. Ferner können verschiedene Schritte der Verfahren in einer anderen Reihenfolge ausgeführt werden, als hier offenbart. In den Ansprüchen schließt das Wort "umfassend" andere Elemente oder Schritte nicht aus und der unbestimmte Artikel "ein" schließt eine Mehrzahl nicht aus. Die bloße Tatsache, dass bestimmte Maßnahmen in voneinander abhängigen Ansprüchen genannt werden, bedeutet nicht, dass eine Kombination dieser Maßnahmen nicht vorteilhaft sein kann. Etwaige Bezugszeichen in den Ansprüchen sollten nicht als Einschränkung des Umfangs der Ansprüche ausgelegt werden.

### Bezugszeichenliste:

- 10: Bereitstellen von Sensordaten
- 20: Bereitstellen eines Auswertungsmodells
- 30: Bereitstellen eines digitalen Modells der Baustelleneinrichtung
- 40: Bereitstellen eines Analyse- und/oder Überwachungsmodells
- 50: System zur Bereitstellung eines digitalen Modells einer Baustelleneinrichtung
- 60: Verarbeitungsschaltung
- 70: Speichermedium
- 80: Datenschnittstelle
- 100: Baustelleneinrichtung/Gerüstsystem
- 110: erster Bereich
- 120: zweiter Bereich
- 130: dritter Bereich
- 200: Vertikalstiel
- 210: Gerüstspindel
- 220: Leitermodul
- 230: Horizontalriegel

## Patentansprüche

1. Computerunterstütztes Verfahren zur Bereitstellung eines digitalen Modells einer Baustelleneinrichtung, insbesondere zur real-time Überwachung der Baustelleneinrichtung, wobei die Baustelleneinrichtung durch Einrichtungselemente aufgebaut wird, umfassend:
Bereitstellen (10) von Sensordaten, umfassend Informationen, die für eine Verwendung eines jeweiligen Einrichtungselements während des Auf-, Ab- oder Umbaus der Baustelleneinrichtung spezifisch sind;
Bereitstellen (20) eines Auswertungsmodells, das eingerichtet ist, um basierend auf den Sensordaten ein digitales Modell der Baustelleneinrichtung bereitzustellen;
Bereitstellen (30) eines digitalen Modells der Baustelleneinrichtung durch Anwendung des Auswertungsmodells und der bereitgestellten Sensordaten.

2. Computerunterstütztes Verfahren nach Anspruch 1, weiterhin umfassend:
Bereitstellen (40) eines Analyse- und/oder Überwachungsmodells, das eingerichtet ist, um Abweichungen von einer vorgegebenen Verwendung des Einrichtungselements und einer Verwendung während des Auf-, Ab- oder Umbaus der Baustelleneinrichtung zu erfassen;
Generieren von Kontroll-, Alarm- und/oder Instruktionsdaten bei Erfassung einer Abweichung durch das Analyse- und/oder Überwachungsmodell, wobei die Kontroll-, Alarm- und/oder Instruktionsdaten vorzugsweise an einen vordefinierten Geräte-Empfängerkreis übermittelt werden.

3. Computerunterstütztes Verfahren nach Anspruch 1 oder Anspruch 2, wobei die Sensordaten zumindest einer der nachfolgenden Sensordaten umfasst:
- Akustikdaten, die während des Ein-, Um- oder Ausbaus zumindest eines Einrichtungselements erfasst wurden und die die beim Ein-, Um- oder Ausbau eines Einrichtungselements auftretenden Geräusche umfasst;
- Bilddaten, die während des Ein-, Um- oder Ausbaus zumindest eines Einrichtungselements erfasst wurden und die dieses Einrichtungselement umfassen;
- Videodaten, die während des Ein-, Um- oder Ausbaus zumindest eines Einrichtungselements erfasst wurden und die dieses Einrichtungselement umfassen;
- Positionsdaten, die während des Ein-, Um- oder Ausbaus zumindest eines Einrichtungselements erfasst wurden und die zumindest eine Position eines Einrichtungselements, einer Bedienperson und/oder einer weiteren Einrichtung während des Ein-, Um- oder Ausbaus des Einrichtungselements umfassen;
- Bewegungsdaten, die während des Ein-, Um- oder Ausbaus zumindest eines Einrichtungselements erfasst wurden und die zumindest eine Bewegung eines Einrichtungselements, einer Bedienperson und/oder einer weiteren Einrichtung während des Ein-, Um- oder Ausbaus des Einrichtungselements zeigen;
- Beschleunigungsdaten, die während des Ein-, Um- oder Ausbaus zumindest eines Einrichtungselements erfasst wurden und die zumindest eine Beschleunigung eines Einrichtungselements, einer Bedienperson und/oder einer weiteren Einrichtung während des Ein-, Um- oder Ausbaus des Einrichtungselements umfassen;
- Schwingungsdaten, die während des Ein-, Um- oder Ausbaus zumindest eines Einrichtungselements erfasst wurden und die zumindest eine mechanische Schwingung eines Einrichtungselements und/oder einer weiteren Einrichtung während des Ein-, Um- oder Ausbaus des Einrichtungselements umfassen;
- Gewichtsdaten, die während des Ein-, Um- oder Ausbaus zumindest eines Einrichtungselements erfasst wurden und die zumindest ein Gewicht eines Einrichtungselements, einer Bedienperson und/oder einer weiteren Einrichtung während des Ein-, Um- oder Ausbaus des Einrichtungselements umfassen; und/oder
- Last- und/oder Dehnungsdaten, die während des Ein-, Um- oder Ausbaus zumindest eines Einrichtungselements erfasst wurden und die durch zumindest einen Dehnungsaufnehmer bereitgestellt wurden, der an einem Einrichtungselement, einer Bedienperson und/oder einer weiteren Einrichtung während des Ein-, Um- oder Ausbaus des Einrichtungselements angeordnet ist.

4. Computerunterstütztes Verfahren nach Anspruch 3, wobei die Positionsdaten unter Einsatz zumindest einer der nachfolgenden Einrichtungen bereitgestellt werden:
- eine satellitenbasierte Positionserfassungseinrichtung, wobei zumindest eine satellitenbasierte Positionserfassungseinrichtung an einem Einrichtungselement, einer Bedienperson und/oder an einer weiteren Baute angeordnet ist;
- eine Sende-Empfangseinheit, wobei zumindest eine Sende-Empfangseinheit an einem Einrichtungselement angeordnet ist;
- eine Sende-Empfangseinheit, wobei zumindest eine Sende-Empfangseinheit an einer Bedienperson angeordnet ist; und/oder
- eine Sende-Empfangseinheit, wobei zumindest eine Sende-Empfangseinheit an einer weiteren Einrichtung angeordnet ist.

5. Computerunterstütztes Verfahren nach einem der vorhergehenden Ansprüche, wobei das Auswertungsmodell zumindest eine Datenbank umfasst, in der für die Verwendung eines jeweiligen Einrichtungselements zumindest eine spezifische Charakteristik hinterlegt ist.

6. Computerunterstütztes Verfahren nach Anspruch 5, wobei die spezifische Charakteristik für die Verwendung eines jeweiligen Einrichtungselements zumindest eine der nachfolgenden spezifischen Charakteristiken umfasst:
- ein Akustikprofil, das die beim Ein-, Um- oder Ausbau eines Einrichtungselements auftretenden Geräuschmuster eines Einrichtungselements, einer Bedienperson und/oder einer sonstigen Einrichtung abbildet;
- ein Bewegungsprofil, das die beim Ein-, Um- oder Ausbau eines Einrichtungselements auftretenden Bewegungsmuster eines Einrichtungselements, einer Bedienperson und/oder einer sonstigen Einrichtung abbildet;
- ein Beschleunigungsprofil, das die beim Ein-, Um- oder Ausbau eines Einrichtungselements auftretenden Beschleunigungsmuster eines Einrichtungselements, einer Bedienperson und/oder einer sonstigen Einrichtung abbildet;
- ein Schwingungsprofil, das die beim Ein-, Um- oder Ausbau eines Einrichtungselements auftretenden Schwingungsmuster eines Einrichtungselements, einer Bedienperson und/oder einer sonstigen Einrichtung abbildet;
- ein Gewicht und/oder eine Gewichtsverteilung, das das beim Ein-, Um- oder Ausbau eines Einrichtungselements auftretende Gewicht und/oder Gewichtsverteilung eines Einrichtungselements, einer Bedienperson und/oder einer sonstigen Einrichtung abbildet;
- eine Last- und/oder Dehnungsprofil, das die während des Ein-, Um- oder Ausbaus auftretende Last- und/oder Dehnungsverteilung eines Einrichtungselements, einer Bedienperson und/oder einer sonstigen Einrichtung abbildet.

7. Computerunterstütztes Verfahren nach einem der vorhergehenden Ansprüche, wobei das Auswertungsmodell zumindest einen trainierten Algorithmus umfasst, der eingerichtet ist, basierend auf den Sensordaten das digitale Modell der Baustelleneinrichtung bereitzustellen.

8. Computerunterstütztes Verfahren nach einem der vorhergehenden Ansprüche, wobei das Auswertungsmodell eingerichtet ist, das digitale Modell der Baustelleneinrichtung basierend auf Positionsdaten und weiteren Sensordaten bereitzustellen.

9. Computerunterstütztes Verfahren nach einem der vorhergehenden Ansprüche, wobei das Auswertungsmodell Zugriff auf die Informationen über die Anzahl der in der Baustelleneinrichtung vorgesehenen Einrichtungselemente für zumindest ein spezifisches Einrichtungselement hat und diese Information beim Bereitstellen des digitalen Modells verarbeitet wird.

10. Computerunterstütztes Verfahren nach einem der vorhergehenden Ansprüche, wobei basierend auf dem digitalen Modell Instruktionsdaten für zumindest eine Bedienperson ausgegeben werden, wobei die Instruktionsdaten auf einem vorgegebenen Auf-, Um- oder Abbauablauf der Baustelleneinrichtung und/oder einem vorgegebenen Auf-, Um- oder Abbauablauf eines Einrichtungselements basieren.

11. Computerunterstütztes Verfahren nach einem der vorhergehenden Ansprüche, wobei basierend auf dem digitalen Modell Validierungsdaten ausgegeben werden, wobei die Validierungsdaten auf einem vorgegebenen Auf-, Um- oder Abbauablauf der Baustelleneinrichtung und/oder einem vorgegebenen Auf-, Um- oder Abbauablauf eines Einrichtungselements basieren.

12. Computerunterstütztes Verfahren nach einem der vorhergehenden Ansprüche, wobei basierend auf dem digitalen Modell Materialsteuerdaten ausgegeben werden, wobei die Materialsteuerdaten auf einem vorgegebenen Auf-, Um- oder Abbauablauf der Baustelleneinrichtung und/oder einem vorgegebenen Auf-, Um- oder Abbauablauf eines Einrichtungselements basieren.

13. System (50) zur Bereitstellung eines digitalen Modells einer Baustelleneinrichtung insbesondere zur real-time Überwachung der Baustelleneinrichtung, umfassend:
eine Verarbeitungsschaltung (60);
ein Speichermedium (70); und
eine Datenschnittstelle (80);
wobei das Speichermedium (70) ein Computerprogramm umfasst, das Anweisungen enthält, die, wenn das Computerprogramm ausgeführt wird, die Verarbeitungsschaltung (60) veranlasst, das Verfahren nach einem der Ansprüche 1 bis 12 auszuführen;
wobei die Datenschnittstelle (80) so konfiguriert ist, dass sie Sensordaten, und das Auswertungsmodell empfängt.

14. Verwendung von Sensordaten und/oder eines Auswertungsmodells in einem Verfahren nach einem der Ansprüche 1 bis 12 und/oder in einem System nach Anspruch 13 zur Bereitstellung eines digitalen Models einer Baustelleneinrichtung.

15. Computer-Programm Element umfassend Anweisungen, die bei Ausführung auf Computergeräten einer Computerumgebung konfiguriert sind, um die Schritte des Verfahrens nach einem der Ansprüche 1 bis 12 in einem System nach Anspruch 13 auszuführen.
